# EUROPEAN PATENT SPECIFICATION

(11) **EP 3 602 087 B1**
(45) Date of publication and mention of the grant of the patent: **18.12.2024**
(21) Application number: 18717383.6
(22) Date of filing: 18.04.2018
(51) Int. Cl.: G01R 31/52, H02M 7/487, G01R 31/42, H02M 7/00

(54) **SHORT CIRCUIT EVENT DETECTION IN ELECTRICAL CONVERTER**
KURZSCHLUSSEREIGNISERKENNUNG IN EINEM ELEKTRISCHEN WANDLER
DÉTECTION D'ÉVÉNEMENT DE COURT-CIRCUIT DANS UN CONVERTISSEUR ÉLECTRIQUE

(30) Priority: 20.04.2017 EP 17167291
(43) Date of publication of application: 05.02.2020
(73) Proprietor: ABB Schweiz AG, 5400 Baden (CH)
(72) Inventor: TRAUB, Felix, 5413 Birmenstorf (CH); SCHMID, Patrick, 5200 Brugg (CH)
(74) Representative: Sykora & König Patentanwälte PartG mbB
(86) International application number: PCT/EP2018/059961
(87) International publication number: WO 2018/193001

(56) References cited:
- EP-A1- 3 116 118
- DE-A1- 102015 009 092
- US-A1- 2011 051 478
- US-A1- 2015 349 521
- FAZIO P ET AL: "Fault detection and reconfiguration strategy for ANPC converters", POWER ELECTRONICS AND MOTION CONTROL CONFERENCE (EPE/PEMC), 2012 15TH INTERNATIONAL, IEEE, 4 September 2012 (2012-09-04), pages DS1b.17 - 1, XP032311822, ISBN: 978-1-4673-1970-6, DOI: 10.1109/EPEPEMC.2012.6397217
- STEFANO FARNESI ET AL: "A new fault tolerant NPC converter system for high power induction motor drives", DIAGNOSTICS FOR ELECTRIC MACHINES, POWER ELECTRONICS&DRIVES (SDEMPED), 2011 IEEE INTERNATIONAL SYMPOSIUM ON, IEEE, 5 September 2011 (2011-09-05), pages 337 - 343, XP032067895, ISBN: 978-1-4244-9301-2, DOI: 10.1109/DEMPED.2011.6063645

## Description

### FIELD OF THE INVENTION

The invention relates to the field of short circuit detection in electrical converters. In particular, the invention relates to a converter device and a method for detecting a short circuit in such a device

### BACKGROUND OF THE INVENTION

In electrical converters, failures of chips or of the gate unit can result in a direct short circuit of the DC link. The resulting short circuit current leads usually to high stress on power modules and DC link capacitors, resulting in explosive release of energy if the short circuit current is not turned off within a very short time interval (such as less than 10 µs).

Current estimation and short circuit detection based on current sensing has been successfully demonstrated for 2-level converters. However, in high current applications, multilevel converter topologies such as T-type or (A)NPC converters are very popular to reduce the required voltage rating of the semiconductor switches and to increase the effective switching frequency of the converter. In a multilevel converter, short circuit events may be detected by detecting a desaturation of IGBT semiconductors in the short circuit path. In order to identify the short circuit path, the information about the position of the desaturated IGBT has to be combined with information about the switching state.

A main challenge for short circuit detection in multilevel converters compared to 2-level converters is the much higher number of commutation and short circuit paths. By consequence, a single current measurement signal is usually not sufficient to detect a short circuit event in a multi-level converter. As an example, there is only one DC-link short circuit path in a 2-level converter. In contrast, in a 3-level ANPC converter, there exist four different DC link short circuit paths and additionally two transfer commutation paths, which are not related to a short circuit path.

Furthermore, the number of switches in the short circuit path may be higher as in the case of a 2-level converter, which also may mean that the short circuit path traverses more than one power module. Depending on the realization and the short circuit current, the short circuit current can traverse an entire power module (i.e., enter and leave the module through the pair of DC terminals), leading to a situation similar to a 2-level converter. In some cases, however, the short circuit current can traverse only a part of a half-bridge power module (e.g., enter through a DC terminal and leave through the AC terminal). This situation usually does not appear in a 2-level converter.

Fazio et al: "Fault detection and reconfiguration strategy for ANPC converters", 15th International Power Electronics And Motion Control Conference, IEEE, 4 September 2012, pages DS1b.17-1 to DS1b.17-5, is a scientific article showing an ANPC type converter, which comprises current sensors in the form of Rogowski coils at special positions within the converter circuit. It is shown that all types of short-circuit paths may be detected with the current sensors. A table is provided, which maps sensor signals compared with thresholds to fault states.

Farnesi et al: "A new fault tolerant NPC converter system for high power induction motor drives", 2011 IEEE International Symposium On Diagnostics For Electric Machines, Power Electronics & Drives (SDEMPED), IEEE, 5 September 2011, pages 337-343, also considers the detection of short-circuit paths.

US 2011/ 051 478 A1 shows a T-type converter with a short-circuit detection and protection circuit, which is adapted for measuring currents through outputs of anti-series connected semiconductor switches.

EP 3 116 118 A1 shows converter cells for a multi-level converter with a gate-driver unit adapted for detecting a short-circuit path through the converter cell.

US 2015/349 521 A1 relates to a method for detecting short-circuit paths in an ANPC type converter.

DE 10 2015 009 092 A1 show Rogowski coils, which surround each of the DC terminals of a power module and which are connected in series. A sum signal of both Rogowski is integrated for detecting errors.

### DESCRIPTION OF THE INVENTION

It is an objective to provide simple means for detecting short circuit events in an electrical multilevel converter, i.e. a converter with more than 2 DC voltage levels.

This objective is achieved by the subject-matter of the independent claims. Further exemplary embodiments are evident from the dependent claims and the following description.

An aspect of the invention relates to a method for detecting a short circuit event in a multi-level converter. A further aspect of the invention relates to an electrical multi-level converter. The electrical converter may be seen as a multilevel converter. It has to be understood that features of the method as described in the above and in the following may be features of the electrical converter as described in the above and in the following, and vice versa.

According to an embodiment of the invention, the electrical converter comprises at least two power modules electrically interconnected with each other to generate a multilevel output Each power module comprises two semiconductor switches electrically connected with each other. The two semiconductor switches of each power module are electrically connected in series or in anti-series between two outputs. In other words, the series or anti-series connection of the two semiconductor switches provides the two (end) outputs at its ends, while an intermediate output may be provided between the two semiconductor switches. The end outputs may be DC outputs, while the intermediate output may be an AC output.

It has to be noted that a semiconductor switch may be one or more semiconductor devices, which are connected in parallel and which receive one collective gate signal, i.e. which are switched simultaneously.

Furthermore, each power modules comprises a current sensor adapted for determining a current along a flow path through the power module. It may be that each power module comprises solely one current sensor, which, however, is adapted for determining a collective current signal, which is indicative of the current through the two outputs.A power module may be a module adapted for converting currents of more than 10 A and/or more than 100 V. It has to be noted that the converter may be a power converter adapted for converting currents of more than 10 A and/or more than 100 V.

A power module may be an assembly, which houses the two semiconductor switches and may provide terminals for electrically interconnecting the power module with further devices, such as further power modules. Also the current sensor may be provided in the power module. Alternatively, the current sensor may be attached to an outside of a housing or to conductors, to which the power module is electrically connected, such as a bus bar. It has to be noted that per power module, there may be only one current sensor but more than one semiconductor switch.

A semiconductor switch may comprise a transistor or thyristor connected in parallel with a free-wheeling diode. For example, the semiconductor switch may comprise an IGBT, IGCT, etc.

The current measured by the current sensor may be measured inside or outside the power module. For example, the current may be a current through a semiconductor switch and/or through the transistor or thyristor. The current also may be a current through a conductor of the power module, such as a terminal. Furthermore, the current may be a current through a conductor outside of the power module, such as a bus bar. The current sensor may have to be arranged that a current along one single flow path through the module may be determined. There may be other current flow paths that are not detectable by the current sensor.

Furthermore, the converter may comprise a controller adapted for performing the method for detecting a short circuit event in a converter as described in the above and in the following. For example, the method may be implemented in software and the controller may comprise a processor on which the software is run. The method also may be implemented at least partially in hardware and/or the controller may comprise an FPGA and/or DSP.

According to an embodiment of the invention, the method comprises: determining at least two current signals with at least two current sensors of the power modules; determining a current signal pattern from the current signals by the comparing each current signal with a threshold; and detecting the short circuit event and identifying a short circuit flow path by searching the current signal pattern in a short circuit event table.

A current signal may be a signal provided by a current sensor. A current signal or current related signal may be a voltage signal that, for example, has been induced in the current sensor based on the current to be measured. It has to be noted that a current signal need not be proportional to the current, which is measured by the current sensor. For example, the current signal may be a signal proportional to a time derivative of the current. Also, a current signal may be indicative of the height of the current through the power module, i.e. as higher the current as higher the signal may be. In the method, at least two different current signals from different current sensors and in particular from different power modules are determined. Thus, currents associated with different power modules are evaluated with the method.

With the method, a current signal pattern is determined from the current signals. A current signal pattern may be seen as data with a data value for every current signal. This data value may be indicative of a state of the current, such as high/low present/not present, etc. A current signal pattern also may be a combined digital signal. By comparing the continuous and/or analogous current signal with one or more thresholds, the information content of the current signal is reduced, for example to only two or three different possible values.

The determined current signal pattern is then searched in a short circuit event table, which may be implemented as a lookup table. For every possible short circuit event and/or short circuit flow path, a pattern indicated of the short circuit event and/or short circuit flow path may be stored in the table. When the determined current signal pattern is found in the table, the corresponding short circuit event along a corresponding flow path may have taken place. A short circuit event may identify a short circuit flow path through the converter, which path may run through one or more power modules. It also may be possible that short circuit event identifies a short circuit in one semiconductor switch.

In general, different commutation events and short circuit events produce characteristic current signal patterns. In such a way, a commutation event, i.e. a regular switching event, may be discriminated from a short circuit event, i.e. an irregular event or fault. Even in a multilevel converter with more than one power module and more than one semiconductor switch per power module, a short circuit event may be detected with less current sensors as semiconductor switches are present. This reduces the number of needed current sensors and the complexity of the logic evaluating the current signals.

With the method, for each power module one collective current signal is determined with the respective current sensor, which collective current signal depends on two currents through the two outputs of the power module. For example, the collective current signal may be a differential current signal. In such a way, it is possible to only have one current signal per power module but to identify the position of a short-circuit event at least so exact that the affected power module can be identified. This may reduce the number of current sensors, which are necessary. Furthermore, the power modules may be standardized with two semiconductor switches and one current sensor, independently of their arrangement within the converter.

According to an embodiment of the invention, for determining a current signal pattern, each current signal is compared with a lower bound for a short circuit current as threshold. In such a way, commutation events may be discriminated from short circuit events. When no current is higher than the lower bound for a short circuit current, it may be assumed that no short circuit event is present.

According to an embodiment of the invention, for each current signal, the current signal pattern is indicative of the current signal higher than the threshold, the current signal lower than a negative value of the threshold and/or the current signal between the negative value of the threshold and the threshold. In other words, the data value from the current signal pattern for a current signal may be one of at least three values: no short circuit current, a positive short circuit current and a negative short circuit current.

However, it also is possible that data value from the current signal pattern for a current signal may be one of two values: no short circuit current, short circuit current present.

According to an embodiment of the invention, a current signal is compared with more than one threshold. For example, there may be a threshold for a low current and a high current. A low current threshold in general may be lower than a high current threshold, which may be a short circuit current threshold. In general it may be that also a low current through one power module in combination with a high current through another module, such as a short circuit current, may help to discriminate different short circuit events.

In this case, the data value from the current signal pattern for the respective current signal may be selected from values discriminating the intervals between the thresholds and/or between the positive and negative values of the thresholds.

According to an embodiment of the invention, thresholds for different current signals are different. For example, there may be different threshold for different power modules. This may be the case, when the power modules are differently designed, for example have a different topology and/or a different current rating.

According to an embodiment of the invention, one current signal is determined for each power module. It may be that every power module is provided with one current sensor and the current signals from all power modules are evaluated.

Alternatively, a number of determined current signals is smaller than a number of power modules. It may be that some power modules do not have a current sensor. For example, it may be that two or more paralleled power modules only have one current sensor, which measures the current from both power modules.

In general, the number of current signals may be smaller or equal to the number of power modules.

According to an embodiment of the invention, the method further comprises: integrating the current signal, which current signal is indicative of a time derivative of the current through the power module; and comparing the integrated current signal with the threshold. For specific current sensors, in particular those that are based on sensing a magnetic field generated by the current, the current signal is indicative of a time derivative of the current. In this case, a signal indicative of the total current may be determined by integrating the current. In general, to detect a short circuit, the original current signal may be post-processed (such as integrated) in a way to get an indicative of the total current. It also may be possible that the current signal is low pass filtered.

It has to be noted that also in the case of a current signal is indicative of a time derivative of the current, the current signal may be directly compared with a threshold for forming the current signal pattern, since also the time derivative of a short circuit current is usually higher than the time derivative of a commutation current.

According to an embodiment of the invention, the method further comprises: blanking the current signals during specific time intervals, for example during time intervals, when the semiconductor switches are switched and the new switching state does not allow a short circuit event. In order to avoid false detections of short circuit events, the current signal from some or all of the current sensors and/or its post-processed form may be blanked during specific time intervals. As an example, transitions where thyristors or transistors are turned on and/or off may be blanked, especially if they result in a state where no short circuit can practically appear.

According to an embodiment of the invention, the method further comprises: optionally allowing the generation of short-circuit signals and overruling a detecting of short circuit events during specific time intervals, for example, when the new switching state does not allow a short circuit event. Blanking also may be implemented by overruling false short circuit detections during blanking periods.

According to an embodiment of the invention, the method further comprises: receiving at least one switching state signal indicative of a switching state of at least one of the semiconductor switches; and identifying the short circuit flow path by searching the current signal pattern and combining with information on the current switching state. For example, switching state may be stored in combination with the current signal patterns in the short circuit event table. A better resolution of the short circuit events may be achieved by additionally including information about the actual switching state of the semiconductor switches of the power modules. In this case, a specific short circuit current path and/or specific failed semiconductor switch may be identified.

The information on the switching state of the power converter also may be used to distinguish a short circuit event from a normal switching and/or commutation event, to identify a short circuit path, to identify the position of a failed chip, or to decide on a proper short circuit turn-off sequence.

In general, the method is applicable to electrical multilevel converters of different topologies, which may have equally designed power modules and/or differently designed power modules.

According to an embodiment of the invention, at least one of the power modules is a half-bridge module comprising two semiconductor switches connected in series between a DC+ output and a DC- output and providing an AC output between them.

According to an embodiment of the invention, the current sensor of the half-bridge module is adapted for measuring a current through one of the DC outputs. For example, the current sensor may measure a current flowing directly through one of the semiconductor switches or through a conductor interconnected with one of the semiconductor switches.

According to an embodiment of the invention, the converter is a 3-level NPC converter comprising two half-bridge modules and a half-bridge diode module. A DC- output of an upper half-bridge module may be connected with the DC+ output of a lower power module. The AC outputs of the half-bridge modules may be interconnected with each other via diodes.

According to an embodiment of the invention, the converter is a 3-Level NPC converter comprising one half-bridge module and two chopper modules, wherein a chopper module may be a series-connection of a diode and an semiconductor switch.

According to an embodiment of the invention, the converter is a 3-level ANPC converter comprising three half-bridge modules, wherein an upper and a lower half-bridge module are interconnected with their AC outputs with the DC outputs of an intermediate half-bridge module. The DC- output of the upper half-bridge module may be connected with the DC+ output of the lower half-bridge module.

According to an embodiment of the invention, at least one of the power modules is a bidirectional switch module comprising two semiconductor switches connected in anti-series between two outputs.

According to an embodiment of the invention, the converter is a T-type converter with two parallel half-bridge modules interconnected with their AC outputs with an output of a bidirectional switch module.

According to an embodiment of the invention, the current sensor is adapted for measuring a current through one of the outputs. It may be that the bidirectional switch module has the same design with respect to its housing as a half-bridge module. The current sensor of the bidirectional switch module may be positioned like the one of a half-bridge module.

According to an embodiment of the invention, the short circuit events comprise current paths flowing through only one power module and/or the short circuit events comprise current paths flowing through more than one power module. In particular, the current paths may flow through differently designed modules, such as a half-bridge module and a bidirectional switch module.

There are different possibilities, how the current signal is measured, such as parasitic emitter inductance voltage sensing, current sensing with a Rogowski coil, and/or current sensing by a pick-up coil coupling to parasitic fields generated by the current.

According to an embodiment of the invention, the current sensor is adapted for measuring a current in one of the semiconductor switches. For example, this may be done by measuring the voltage drop on a bonding inductance of the semiconductor switch.

According to an embodiment of the invention, the current sensor is adapted for measuring a current in a power terminal of the power module and/or bus bar interconnected with the power terminal of the power module. For example, the time derivative of the current may be determined in the conductor with a Rogowski coil around the conductor.

According to another embodiment, one or more sensing coils may be positioned to couple to parasitic fields emitted by the power module and/or one or more of its interconnections. The transient magnetic fields produce a proportional voltage in the sensing coil as current signal.

For example, if a Rogowski coil is applied to the DC- terminal of a half-bridge module, the collector current of the lower semiconductor switch may be measured.

According to an embodiment of the invention, the current sensor is adapted for providing a collective current signal depending on two currents through two outputs of the power module. For example, the collective signal may depend on the currents through the DC outputs of a half-bridge module. In the case, only one current is present, the collective signal may be high and in the case, when both currents are substantially the same, the collective current signal may be low.

For example, the collective current signal may be indicative of a differential current of two outputs of the power module, the differential current being a difference between a current into the one output and a current out of the other output. Such a differential signal may be provided by a Rogowski coil around both conductors connected to the two outputs. For example, the Rogowski coil may be positioned around both corresponding terminals of the power module, which terminals may be positioned next to each other.

A collective current signal may be provided by a pick-up coil arrangement, which comprises several measurement coils positioned near the two conductors. The pick-up coil arrangement may couple to parasitic fields emitted by the conductors, such as wire bonds, power module terminals, or bus bars. The measurement coils may be positioned, such that a sum signal from the coils, for example provided by series and/or anti-series connecting the measurement coils, is high, when the difference between the currents is low and may be high, when the difference between the currents is high, which may be the case, when one of the currents is substantially zero and the other one is present.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a power module used in a converter according to an embodiment of the invention.
Fig. 2 schematically shows a power module used in a converter according to an embodiment of the invention.
Fig. 3 schematically shows a power module used in a converter according to an embodiment of the invention.
Fig. 4A to 4F schematically show a converter according to an embodiment of the invention in different states.
Fig. 5A to 5C schematically show a converter according to an embodiment of the invention in different states.
Fig. 6 shows a flow diagram for a method for detecting a short circuit event according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

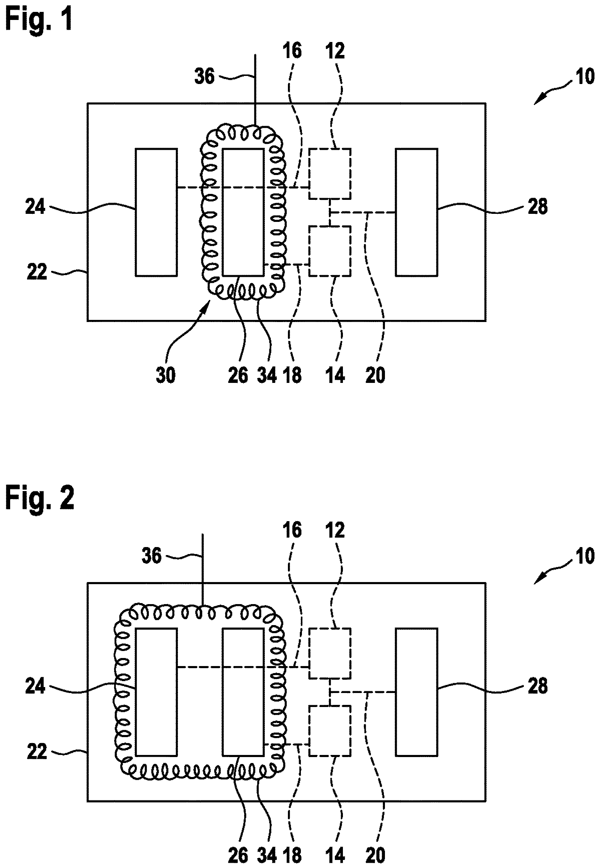

Fig. 1 shows a power module 10, which comprises two semiconductor switches 12, 14 connected in series. Each semiconductor switch 14 comprises a thyristor or transistor, i.e. a switchable semiconductor element, connected in parallel with a free-wheeling diode. The series connection of semiconductor switches 12, 14 provides a DC+ output 16 and a DC-output 18 at its ends. Between the semiconductor switches 12, 14, an AC output 20 is provided.

The power module 10 comprises a housing 22, in which the semiconductor switches 12 are accommodated. The DC+ output 16, DC- output 18 and AC output 20 are connected with a DC+ terminal 24, a DC- terminal 26, and an AC terminal 28, respectively, which protrude from the housing 22 from one side.

As shown in Fig. 1, the power module 10 furthermore comprises a current sensor 30, which is adapted for measuring a current through the DC- terminal 26. In Fig. 1, a Rogowski coil 34 is shown, which surrounds the DC- terminal 26. A magnetic field generated by the DC-terminal induces a voltage signal in the Rogowski coil 34, which is indicative of a time derivative of the current through the DC- terminal 26 and which may be used as current signal 36.

The current sensor 30 and in particular the Rogowski coil 34 also may surround the DC+ terminal 24 or any other conductor connected with the DC+ output 16 or the DC- output 18.

The DC+ terminal 24 and the DC- terminal 26 are arranged side by side. Each of the DC terminals 24, 26 generates a magnetic field based on the time derivate dI/dt of the current flowing through it. The two magnetic fields add up to an effective magnetic field indicative of the time derivative of a current, which is the difference of the current flowing into the DC+ terminal 24 and flowing out of the DC- terminal 26. This magnetic field may be transformed into a collective current signal 32 by a Rogowski coil 34 surrounding both DC terminals 24, 26. The Rogowski coil 34 of Fig. 2 generates a voltage signal indicative of a time derivative of a difference between the currents through the DC outputs 16, 18 and may be used as a further type of current signal 36. The difference of the currents through the DC outputs 16, 18 is the current flwoing through the AC terminal 28.

The current sensor 30 and in particular the Rogowski coil 34 also may surround any other conductors connected with both the DC+ output 16 or the DC- output 18.

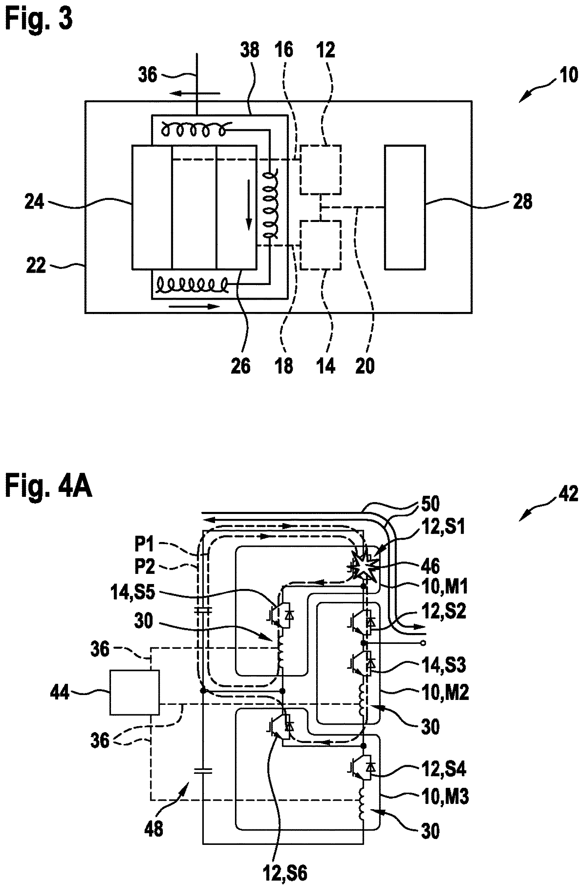

Fig. 3 shows a further possibility, how a collective current signal 36 may be generated. A pick-up coil arrangement 38 is shown, which comprises several coils 40, 40', 40" arranged around the DC terminals 24, 26, which coils 40, 40', 40" may be integrated into a printed circuit board. As indicated by the arrows, the coils 40, 40' on opposite sides of the DC terminals 24, 26 may be wound in the same direction with respect to a direction around the DC terminals 24, 26. A further coil 40" at a further side of the DC terminals 24, 26 may be wound in the opposite direction. The coils 40, 40', 40" may be connected in series and/or the number of conductor loops per coil 40, 40', 40" may be chosen such that the magnetic fields from the DC terminals 24, 26 induce a sum voltage in the series connection of coils 40, 40', 40", which is based on the time derivatives of the currents through the DC terminals 24, 26. The sum voltage of the coils 40, 40', 40" then may be used as collective current signal 36.

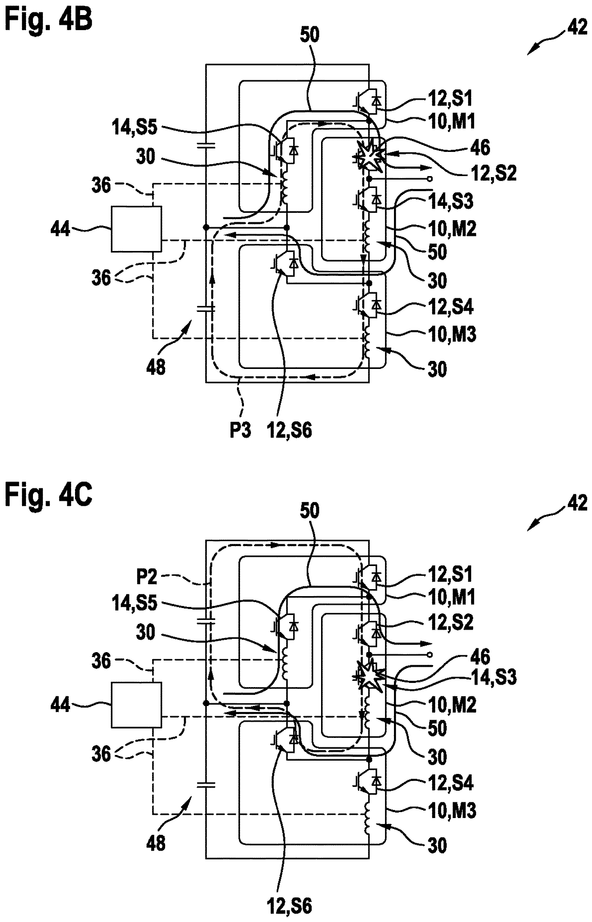

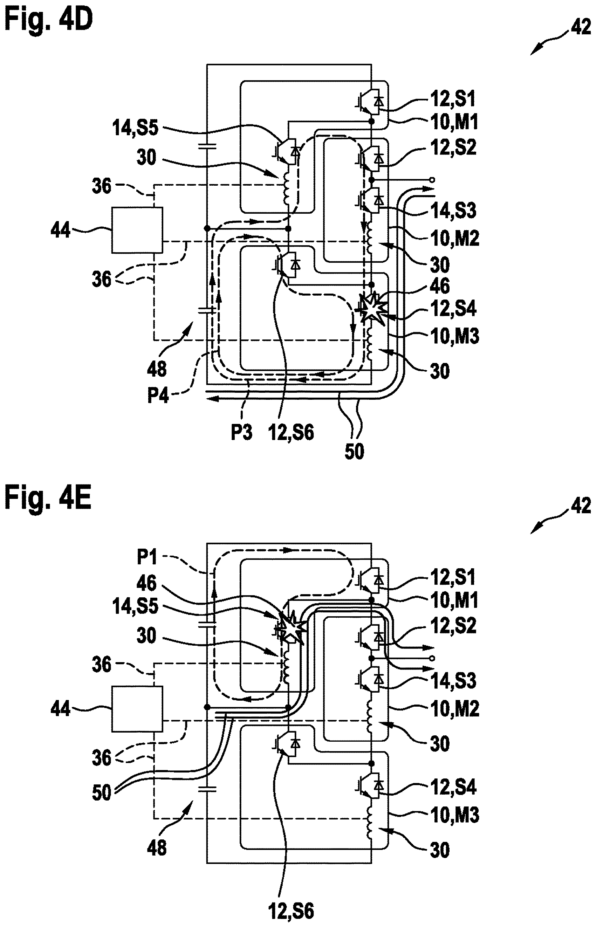

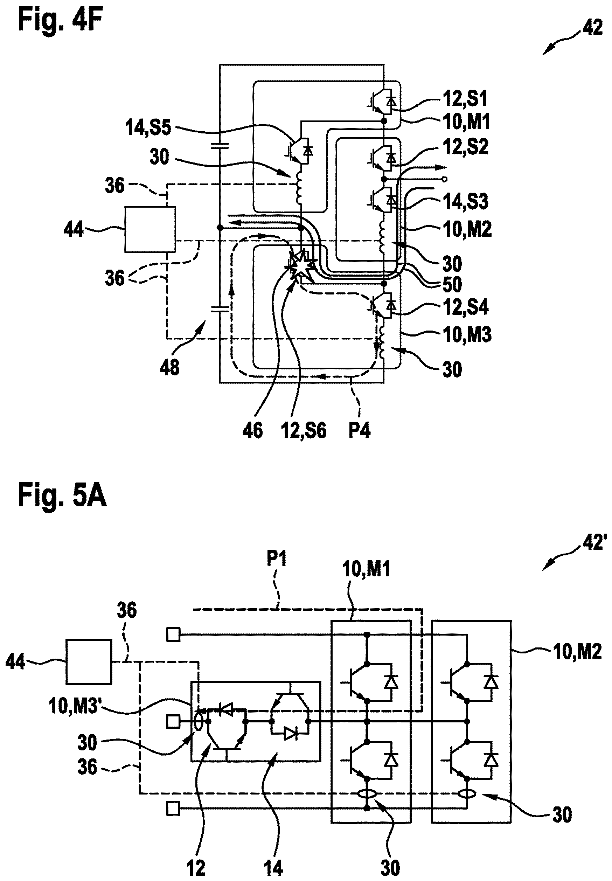

Fig. 4A to 4F show an electrical converter 42 that is composed of half-bridge power modules M1, M2, M3 that may be designed like the ones shown in Fig. 1 to 3. In Fig. 4A to 4F, a further alternative for a current sensor 30 is shown, which may be a sensor adapted for bonding inductance measurement, i.e. the current sensor 30 may be adapted for measuring the current through one or more bonding wires, for example like in Fig. 1 to 3. In particular, the current sensor 30 is adapted for measuring a current through the lower semiconductor switch 14.

The current signals 36 from the current sensors are sent to a controller 44, which is adapted for detecting a short circuit event 46 in the converter 42.

The converter 42 is a 3-level ANPC converter constructed from the half-bridge power modules M1, M2 and M3 in the following way: The middle power module M2 is connected with its DC+ output with the AC output of upper power module M1 and is connected with its DC- output with the AC output of the lower power module M3. The upper power module M1 is connected with its DC- output with the DC+ output of the lower power module M3.

The midpoint of the middle power module M2 provides the AC output of the converter 42. The DC+ output of the upper power module M1 is connected with the positive point of a split DC link 48. The DC- output of the upper power module M1 respectively the DC+ output of the lower power module M3 is connected with the midpoint point of the DC link 48. The DC- output of the lower power module M3 is connected with the negative point of the DC link 48.

The semiconductor switches 12, 14 of the power modules M1, M2, M3 are numbered in the following way: Power module M1 contains semiconductor switches S1 and S5. Power module M2 contains semiconductor switches S2 and S3. Power module M3 contains semiconductor switches S6 and S4.

Fig. 4A to 4F show the converter 42 in different switching states, which are listed in a table below. For each figure, the current paths 50 during normal operation in this state, i.e. when none of the semiconductor switches is failed, and short circuit paths P1, P2, P3, P4 in the case of a failure of one of the semiconductor switches S1 to S6 are shown.

In the cases of Fig. 4A and 4D, there are two overlapping short circuit paths, namely the shorter and longer upper short circuit paths P1 and P2, and the shorter and longer lower short circuit paths P3 and P4.

In the following table, the figures, the corresponding short circuit paths and the switching states of the switches S1 to S6 are listed. In general, the current signals 36 from the current sensors 30 may be positive or negative, and they may have different magnitudes. However, the current signals 36 may be classified according to the following scheme as indicated in the table: "+" indicates a current that is higher than a lower bound for the short circuit current, "-" indicates a current that is lower than the negative value of the lower bound and "0" indicates a current in between.

| | **Path** | **S1** | **S2** | **S3** | **S4** | **S5** | **S6** | **M1** | **M2** | **M3** |
|---|---|---|---|---|---|---|---|---|---|---|
| **Fig. 4A** | P1 | fail | on | off | off | on | off | + | 0 | 0 |
| | P1,P2 | fail | on | on | off | on | n.a. | + | + | 0 |
| | P2 | fail | on | on | off | off | n.a. | 0 | + | 0 |
| **Fig. 4B** | P3 | off | fail | on | on | off | off | - | + | + |
| **Fig. 4C** | P2 | on | on | fail | off | off | off | 0 | + | 0 |
| **Fig. 4D** | P3 | off | on | on | fail | n.a. | off | - | + | + |
| | P3,P4 | off | on | on | fail | n.a. | on | - | + | + |
| | P4 | off | off | on | fail | off | on | 0 | 0 | + |
| **Fig. 4E** | P1 | on | on | off | off | fail | off | + | 0 | 0 |
| **Fig. 4F** | P4 | off | off | on | on | off | fail | 0 | 0 | + |

It can be seen that every short circuit path P1 to P4 has a characteristic signature. In other words, every short circuit current path P1 to P4 is related to a corresponding current signal pattern, which can be determined by comparing the three different current signals of the power modules M1, M2, M3 with a threshold.

The following table shows the short circuit paths and the corresponding current signal patterns.

| **Short circuit path** | **Event** | **Current signal pattern** | | |
|---|---|---|---|---|
| | | **M1** | **M2** | **M3** |
| **P1** | S5 | + | 0 | 0 |
| **P2** | S3 | 0 | + | 0 |
| **P1, P2** | S1 | + | + | 0 |
| **P3** | S2 | - | + | + |
| **P4** | S6 | 0 | 0 | + |
| **P3, P4** | S4 | - | + | + |

The controller 44 may compare the current signals 36 with the threshold and may determine a current signal pattern for the converter 42. For example, this may be performed regularly, and/or after every switching event. When the determined current signal pattern is found in the above table, which may be stored in the controller 44, the controller 44 is able to determine the short circuit paths P1 to P4, which are present in the short circuit event 46 and the semiconductor switch S1 to S6, which has failed.

In the case of Fig. 4A to 4F, the short circuit events 46 can be read from the current signal pattern in a unique way. In particular, no two short circuit paths produce the same current signal pattern. However, this does not necessarily need to be the case in general. In general, the current signal pattern may allow to identify the short circuit path, but does not in general may allow to identify the position of the failed semiconductor switch 12, 14. In order to detect a position of a failed semiconductor switch 12, 14, the available information about the short circuit path may have to be combined with information about the state of the semiconductor switches 12, 14.

It also has to be noted that the short circuit path P1 to P4 is not necessarily detected by the power module M1, M2, M3, 10, which comprises the semiconductor switch 12, 14 that has to be turned off in order to break the short circuit path P1 to P4. Thus, with the information about the short circuit event 46, the controller 44 may break the short circuit path due to a failure in one power module 10 by switching a semiconductor switch 12, 14 of another power module 10.

Fig. 5A to 5BC show an electrical converter 42' that is composed of half-bridge power modules M1, M2, M3' that may be designed like the ones shown in Fig. 1 to 3. Contrary to Fig. 1 to Fig. 3, the power module M3' is a bidirectional switch module with the semiconductor switches 12, 14 connected in anti-series.

In the T-type converter 42, the half-bridge power modules M1 and M2 are connected in parallel each other via their DC+ outputs, DC- outputs and AC outputs. The DC+ outputs and the DC- outputs of the power modules M1 and M2 may be connected with the positive point and the negative point of a split DC link. The bidirectional switch module M3' is connected with one output to the neutral point of the DC link and with the other output to the AC outputs of the power modules M1 and M2 which also provide an AC output of the converter 42'.

Again as with respect to the converter 42 of Fig. 4A to 4F, the commutation paths or equivalently short circuit paths P1, P2, P3 are not necessarily contained in a single power module M1, M, M3'. For example, as shown in Fig. 5A, the short circuit path P1 from the positive point of the DC link to the neutral point only involves the path from the DC+ output to the AC output of the half-bridge power modules M1 and M2.

For example, the current signals 36 of the T-type converter 42' may be generated by dI/dt sensing with a pick-up coil arrangement as shown in Fig. 3. However, also other current measurement methods may be applicable.

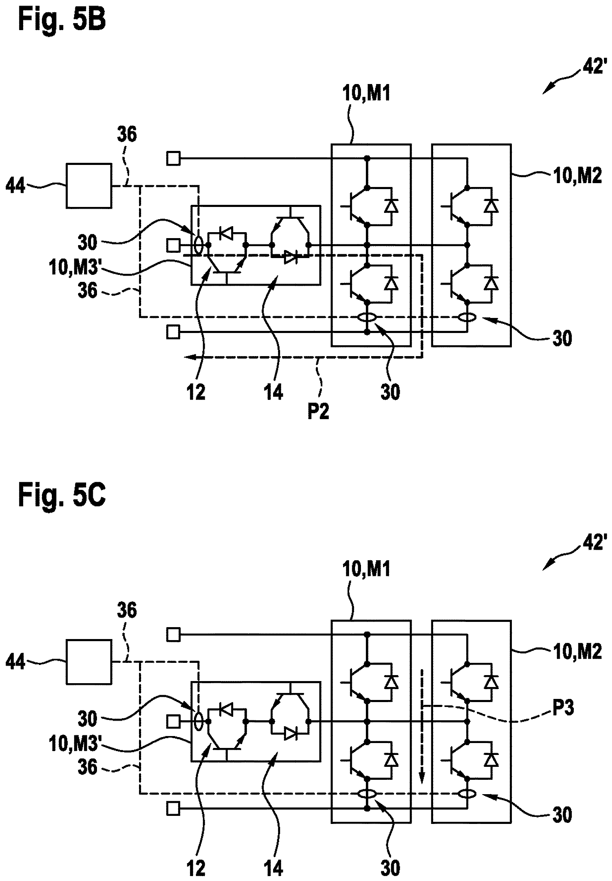

Other as indicated in Fig. 5A, with a pick-up coil arrangement 38 as current sensor 30, a collective current signal 36 is generated, which is based on the currents through both DC outputs of the respective module M1 and M2 or both outputs of the module M'. The pick-up coil arrangement 38 may have a stronger coupling coefficient to time derivatives of currents flowing from one DC output to the AC output compared to the ones between the DC outputs. The short circuit paths P1 and P2 shown in Fig. 5A and 5B lead to a higher collective current signal 36 as the short circuit path P3 of Fig. 5C, which, however, is based on the same magnitude of current.

The following table shows current signal patterns based on collective current signals 36 produced by the pick-up coil arrangements 38 of the modules M1, M2, M3'. In the table, "s" indicates a high absolute value of the collective current signals 36 and "w" indicates a weak collective current signal 36. The values high and weak may be decimated with two different thresholds. The value "0" indicates a collective current signal 36 of substantially 0.

| | **M1, M2** | **M3'** |
|---|---|---|
| **Fig. 5A** | -s | +w |
| **Fig. 5B** | +s | -w |
| **Fig. 5C** | +w | 0 |

Again, the controller 44 may distinguish the short circuit paths P1 to P3 based on the current signal patterns.

The coupling on the bidirectional switch module M3' may always have a relatively weak coupling coefficient, since the current is flowing through both of its terminals and/outputs. The current signal 36 detected with the current sensor 30 of the module M3 may be used to distinguish normal switching versus a short circuit event in the case of Fig. 5A and 5B. In this case, the current signals from M1 and M2 may be ignored, thereby avoiding false short circuit detections due to the different coupling coefficients.

Based on the sign of the current signal 36, the two short circuit paths P1 and P2 from DC+ to NP and from NP to DC- can be distinguished. Additionally, using information about the switching state, the position of the failed semiconductor switch 12, 14 may be uniquely identified.

If the current signal 36 from the bidirectional switch module M3' is 0, the current signals 36 of the power modules M1 and M2 may be analyzed. This situation corresponds to Fig. 5C. The DC+ to DC- short circuit path P3 may be detected by integration of the current signals 36 from the modules M1, M2, which in the case of a pick-up coil arrangement correspond to a time derivate of a current, in order to estimate the current through the modules M1, M2.

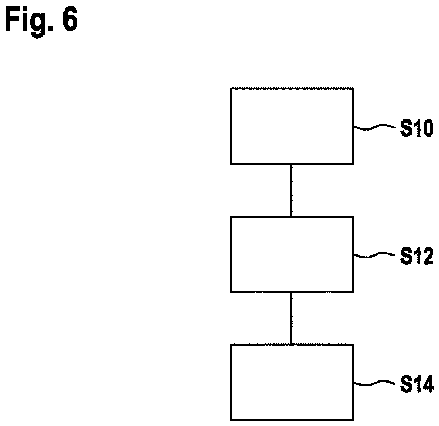

Fig. 6 shows a flow diagram for a method for detecting a short circuit event 46 in a converter 42, 42', which may be performed by the controller 44.

In step S10, at least two current signals 36 are determined with at least two current sensors 30 of the power modules M1, M2, M3, M3'. As described with respect to Fig.1 to 3, the current signals may be voltage signals provided by coils, in which the voltage signals are induced based on a current through the respective power module M1, M2, M3, M3'.

It also may be possible that the current signals are collective current signals that are indicative of the relationship of two or more currents through a power module 10, such as the currents through DC outputs of the modules M1, M2, M3 or the currents through the outputs of the module M'.

It is furthermore possible that one current signal 36 is determined for each power module M1, M2, M3, M3' or, alternatively, that a number of determined current signals 36 is smaller than a number of power modules M1, M2, M3, M3'. For example, in the case of Fig. 4A to 4F, three current signals 36 are determined for three power modules M1, M2, M3. In the case of Fig. 5A to 5C, for the modules M1 and M2, only one current signal 36 may be necessary.

Furthermore, the current signals 36 may be indicative of a time derivate of the current(s) to be measured. In such a case, all or some of the current signals 36 may be integrated. For example, in the case of Fig. 5A to 5C, only the current signals 36 from the modules M1 and M2 may be integrated.

It also may be that the current signals 36 are blanked, i.e. set to 0, for example in time intervals, during which the semiconductor switches 12, 14 of the modules M1, M2, M3, M3' are switched. In such a way, false detections may be suppressed.

In step S12, a current signal pattern is determined from the current signals 36. This may be done by comparing each current signal 36 with a threshold. For example, in the embodiment of Fig. 4A to 4F, each current signal 36 is compared with a lower bound for a short circuit current as threshold.

There may be more than one threshold for a specific current signal 36 from a specific power module. This is the case for the embodiment shown in Fig. 5A to 5C, where thresholds for weak and strong current signals are present. It also may be that thresholds for current signals 36 from different power modules are different.

With the thresholds, the current signals 36 may be associated to different categories, such as the "-", "0" and "+" of the embodiment of Fig. 4A to 4F. From these categories, the current signal pattern may be composed.

In step S14, the short circuit event 46 is determined by searching the current signal pattern in a short circuit event table. Such tables are shown in the above. The short circuit event table may be stored as a table in the controller. However, it also may be possible that only parts of the table are stored and that another part (or the complete table) is implemented as program logic. For example, in the embodiment of Fig. 5A to 5C, the current signals of power modules M1 and M2 only may be evaluated, when the current signal of M3' is in the category "0".

It is also possible that the controller receives and/or uses at least one switching state signal indicative of a switching state of at least one of the semiconductor switches 12, 14 of the power modules M1, M2, M3, M3'. Then, the short circuit event 36 may be identified additionally based on the switching state. Also, specific switching states may be part of the short circuit event table.

Based on the short circuit event 36 that was identified, the controller 44 may select a semiconductor switch 12, 14 that has to be shut off for breaking a short circuit path P1 to P4.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: power module, half-bridge module
- 12: upper semiconductor switch
- 14: lower semiconductor switch
- 16: DC+ output
- 18: DC- output
- 20: AC output
- 24: DC+ terminal
- 26: DC- terminal
- 28: AC terminal
- 30: current sensor
- 34: Rogowski coil
- 36: current signal
- 38: pick-up coil arrangement
- 40: coil
- 40': coil
- 40": coil
- 42: ANPC converter
- 42': T-type converter
- 44: controller
- 46: short circuit event
- 48: DC link
- 50: current path
- M1: half-bridge power module
- M2: half-bridge power module
- M3: half-bridge power module
- M3': bidirectional switch power module
- P1 to P4: short circuit path
- S1 to S6: semiconductor switch

## Claims

1. A method for detecting a short circuit event (46) in a multi-level converter (42, 42'),
wherein the converter (42) is composed of at least two power modules (M1, M2, M3, M3') electrically interconnected with each other to generate a multilevel output, and each of the power modules comprises a current sensor (30) adapted for determining a current along a flow path through the power module (M1, M2, M3, M3');
wherein each power module comprises two semiconductor switches (12, 14) electrically connected in series or anti-series between two outputs (16, 18) with each other, wherein the two outputs are connected with two terminals (24, 26), which are positioned next to each other;
the method comprising:
determining for each power module (M1, M2, M3, M3') one collective current signal (36) with a current sensor (30, 34, 38) of the respective power module, which collective current signal (36) depends on two currents through the two outputs (16, 18) of the power module (M1, M2, M3, M3');
determining a current signal pattern from the collective current signals (36) by comparing each collective current signal with a threshold;
detecting the short circuit event (46) and identifying a short circuit flow path (P1 to P4) by searching the current signal pattern in a short circuit event table;
**characterized in that**
the collective current signal is indicative of a differential current of the two outputs of the power module, the differential current being a difference between a current into the one output and a current out of the other output;
a) the current sensor comprises a Rogowski coil that surrounds the two terminals; or
b) the current sensor comprises a pick-up coil arrangement, which comprises several measurement coils (40, 40', 40") arranged on opposite sides and a further side of the two terminals (24, 26), wherein the measurement coils (40, 40') on opposite sides of the terminals (24, 26) are wound in the same direction with respect to a direction around the terminals (24, 26) and the measurement coil (40") at a further side of the terminals (24, 26) is wound in the opposite direction.

2. The method of claim 1,
wherein for determining a current signal pattern, each collective current signal (36) is compared with a lower bound for a short circuit current as threshold;
wherein for each collective current signal (36), the current signal pattern is indicative of the collective current signal higher than the threshold, the collective current signal lower than a negative value of the threshold and/or the collective current signal between the negative value of the threshold and the threshold.

3. The method of one of the preceding claims,
wherein a collective current signal (36) is compared with more than one threshold; wherein thresholds for different collective current signals (36) are different.

4. The method of one of the preceding claims, further comprising:
integrating the collective current signal (36), which collective current signal (36) is indicative of a time derivative of the current through the power module (M1, M2, M3, M3');
comparing the integrated collective current signal with the threshold.

5. The method of one of the preceding claims, further comprising:
blanking the collective current signals during specific time intervals; or
overruling a detecting of short circuit events during specific time intervals.

6. The method of one of the preceding claims, further comprising:
receiving at least one switching state signal indicative of a switching state of at least one of the semiconductor switches (12, 14);
identifying the short circuit flow path (P1 to P4) by searching the current signal pattern and combining with information on the current switching state.

7. The method of one of the preceding claims,
wherein at least one of the power modules (M1, M2, M3) is a half-bridge module comprising two semiconductor switches (12, 14) connected in series between a DC+ output (16) and a DC- output (18) and providing an AC output (20) between them.

8. The method of claim 7,
wherein the converter is a 3-level NPC converter (42) comprising two half-bridge modules and a half-bridge diode module; and/or
wherein the converter is a 3-Level NPC converter (42) comprising one half-bridge module and two chopper modules; and/or
wherein the converter is a 3-level ANPC converter (42) comprising three half-bridge modules (M1, M2, M3), wherein two half-bridge modules are interconnected with their AC outputs (20) with the DC outputs (16, 18) of a third half-bridge module.

9. The method of one of the preceding claims,
wherein at least one of the power modules is a bidirectional switch module (M3') comprising two semiconductor switches (12, 14) connected in anti-series between two outputs;
wherein the converter is a T-type converter (42') with two parallel half-bridge modules (M1, M2) interconnected with their AC outputs (20) with an output of a bidirectional switch module (M3').

10. The method of one of preceding claims,
wherein the current sensor (30) is adapted for measuring a current in a power terminal (24, 26) of the power module and/or bus bar interconnected with the power terminal of the power module.

11. An electrical multi-level converter (42, 42'), comprising:
at least two power modules (M1, M2, M3, M3') electrically interconnected with each other, each power module comprising two semiconductor switches (12, 14) electrically connected with each other and each power module comprises a current sensor (30) adapted for determining a current through the power module;
a controller (44) adapted for performing the method of one of the preceding claims;
wherein each power module comprises two semiconductor switches (12, 14) electrically connected in series or anti-series between two outputs (16, 18) of the power module with each other, wherein the two outputs are connected with two terminals (24, 26), which are positioned next to each other;
wherein the current sensor (30) of each power module is adapted for determining a collective current signal (36), which depends on two currents through the two outputs (16, 18) of the power module (M1, M2, M3, M3');
**characterized in that**
the current sensor comprises a Rogowski coil that surrounds the two terminals; or
the current sensor comprises a pick-up coil arrangement, which comprises several measurement coils (40, 40', 40") arranged on opposite sides and a further side of the two terminals (24, 26), wherein the measurement coils (40, 40') on opposite sides of the terminals (24, 26) are wound in the same direction with respect to a direction around the terminals (24, 26) and the measurement coil (40") at a further side of the terminals (24, 26) is wound in the opposite direction.

## Patentansprüche

1. Verfahren zum Erkennen eines Kurzschlussereignisses (46) in einem Mehrstufen-Umrichter (42, 42'),
wobei der Umrichter (42) aus mindestens zwei Leistungsmodulen (M1, M2, M3, M3') besteht, die elektrisch miteinander verbunden sind, um eine mehrstufige Leistungsabgabe zu erzeugen, und jedes der Leistungsmodule einen Stromsensor (30) umfasst, der zum Bestimmen eines Stroms entlang eines Flusswegs durch das Leistungsmodul (M1, M2, M3, M3') ausgelegt ist;
wobei jedes Leistungsmodul zwei Halbleiterschalter (12, 14) umfasst, die elektrisch in Reihe oder Gegenreihe zwischen zwei Ausgängen (16, 18) miteinander verbunden sind, wobei die beiden Ausgänge mit zwei Anschlüssen (24, 26) verbunden sind, die nebeneinander angeordnet sind;
wobei das Verfahren Folgendes umfasst:
Bestimmen, für jedes Leistungsmodul (M1, M2, M3, M3'), eines kollektiven Stromsignals (36) mit einem Stromsensor (30, 34, 38) des jeweiligen Leistungsmoduls, wobei das kollektive Stromsignal (36) von zwei Strömen durch die beiden Ausgänge (16, 18) des Leistungsmoduls (M1, M2, M3, M3') abhängt;
Bestimmen eines Stromsignalmusters aus den kollektiven Stromsignalen (36) durch Vergleichen jedes kollektiven Stromsignals mit einem Schwellenwert;
Erkennen des Kurzschlussereignisses (46) und Identifizieren eines Kurzschlussflusspfades (P1 bis P4) durch Suchen des aktuellen Signalmusters in einer Kurzschlussereignistabelle;
**dadurch gekennzeichnet, dass**
das kollektive Stromsignal einen Differenzstrom der beiden Ausgänge des Leistungsmoduls anzeigt, wobei der Differenzstrom eine Differenz zwischen einem Strom in den einen Ausgang und einem Strom aus dem anderen Ausgang ist;
a) der Stromsensor eine Rogowski-Spule umfasst, die die beiden Anschlüsse umgibt; oder
b) der Stromsensor eine Aufnehmerspulenanordnung umfasst, die mehrere auf gegenüberliegenden Seiten und einer weiteren Seite der beiden Anschlüsse (24, 26) angeordnete Messspulen (40, 40', 40") umfasst, wobei die Messspulen (40, 40') auf gegenüberliegenden Seiten der Anschlüsse (24, 26) in Bezug auf eine Richtung um die Anschlüsse (24, 26) gleichsinnig gewickelt sind und die Messspule (40") auf einer weiteren Seite der Anschlüsse (24, 26) gegensinnig gewickelt ist.

2. Verfahren nach Anspruch 1,
wobei zum Bestimmen eines Stromsignalmusters jedes kollektive Stromsignal (36) mit einer Untergrenze für einen Kurzschlussstrom als Schwellenwert verglichen wird;
wobei für jedes kollektive Stromsignal (36) das Stromsignalmuster das kollektive Stromsignal höher als der Schwellenwert, das kollektive Stromsignal niedriger als ein negativer Wert des Schwellenwerts und/oder das kollektive Stromsignal zwischen dem negativen Wert des Schwellenwerts und dem Schwellenwert anzeigt.

3. Verfahren nach einem der vorhergehenden Ansprüche, wobei ein kollektives Stromsignal (36) mit mehr als einem Schwellenwert verglichen wird;
wobei die Schwellenwerte für verschiedene kollektive Stromsignale (36) unterschiedlich sind.

4. Verfahren nach einem der vorhergehenden Ansprüche, das ferner Folgendes umfasst:
Integrieren des kollektiven Stromsignals (36), wobei das kollektive Stromsignal (36) für eine zeitliche Ableitung des Stroms durch das Leistungsmodul (M1, M2, M3, M3') kennzeichnend ist;
Vergleichen des integrierten kollektiven Stromsignals mit dem Schwellenwert.

5. Verfahren nach einem der vorhergehenden Ansprüche, das ferner Folgendes umfasst:
Ausblenden der kollektiven Stromsignale während bestimmter Zeitintervalle; oder
Außerkraftsetzen eines Erkennens von Kurzschlussereignissen während bestimmter Zeitintervalle.

6. Verfahren nach einem der vorhergehenden Ansprüche, das ferner Folgendes umfasst:
Empfangen von mindestens einem Schaltzustandssignal, das einen Schaltzustand von mindestens einem der Halbleiterschalter (12, 14) anzeigt;
Identifizieren des Kurzschlussflusspfades (P1 bis P4) durch Suchen des aktuellen Signalmusters und Kombinieren mit Informationen über den aktuellen Schaltzustand.

7. Verfahren nach einem der vorhergehenden Ansprüche, wobei mindestens eines der Leistungsmodule (M1, M2, M3) ein Halbbrückenmodul ist, das zwei Halbleiterschalter (12, 14) umfasst, die zwischen einem DC+-Ausgang (16) und einem DC--Ausgang (18) in Reihe geschaltet sind und einen AC-Ausgang (20) zwischen ihnen bereitstellen.

8. Verfahren nach Anspruch 7,
wobei der Umrichter ein 3-Stufen-NPC-Umrichter (42) ist, der zwei Halbbrückenmodule und ein Halbbrückendiodenmodul umfasst; und/oder
wobei der Umrichter ein 3-Stufen-NPC-Umrichter (42) ist, der ein Halbbrückenmodul und zwei Chopper-Module umfasst; und/oder
wobei der Umrichter ein 3-Stufen-ANPC-Wandler (42) ist, der drei Halbbrückenmodule (M1, M2, M3) umfasst, wobei zwei Halbbrückenmodule mit ihren AC-Ausgängen (20) mit den DC-Ausgängen (16, 18) eines dritten Halbbrückenmoduls verbunden sind.

9. Verfahren nach einem der vorhergehenden Ansprüche, wobei mindestens eines der Leistungsmodule ein bidirektionales Schaltmodul (M3') ist, das zwei Halbleiterschalter (12, 14) umfasst, die zwischen zwei Ausgängen in Gegenserie geschaltet sind;
wobei der Umrichter ein T-Typ-Umrichter (42') mit zwei parallelen Halbbrückenmodulen (M1, M2) ist, die mit ihren AC-Ausgängen (20) mit einem Ausgang eines bidirektionalen Schaltmoduls (M3') verbunden sind.

10. Verfahren nach einem der vorhergehenden Ansprüche, wobei der Stromsensor (30) zum Messen eines Stroms in einem Leistungsanschluss (24, 26) des Leistungsmoduls und/oder einer mit dem Leistungsanschluss des Leistungsmoduls verbundenen Sammelschiene ausgelegt ist.

11. Elektrischer Mehrstufen-Umrichter (42, 42'), der Folgendes umfasst:
mindestens zwei Leistungsmodule (M1, M2, M3, M3'), die elektrisch miteinander verbunden sind, wobei jedes Leistungsmodul zwei Halbleiterschalter (12, 14) umfasst, die elektrisch miteinander verbunden sind, und jedes Leistungsmodul einen Stromsensor (30) umfasst, der ausgelegt ist, um einen Strom durch das Leistungsmodul zu bestimmen;
einen Controller (44), der zum Durchführen des Verfahrens nach einem der vorhergehenden Ansprüche ausgelegt ist;
wobei jedes Leistungsmodul zwei Halbleiterschalter (12, 14) umfasst, die elektrisch in Reihe oder Gegenreihe zwischen zwei Ausgängen (16, 18) des Leistungsmoduls miteinander verbunden sind, wobei die beiden Ausgänge mit zwei Anschlüssen (24, 26) verbunden sind, die nebeneinander angeordnet sind;
wobei der Stromsensor (30) jedes Leistungsmoduls zum Bestimmen eines kollektiven Stromsignals (36) ausgelegt ist, das von zwei Strömen durch die beiden Ausgänge (16, 18) des Leistungsmoduls (M1, M2, M3, M3') abhängt;
**dadurch gekennzeichnet, dass**
der Stromsensor eine Rogowski-Spule umfasst, die die beiden Anschlüsse umgibt; oder
der Stromsensor eine Aufnehmerspulenanordnung umfasst, die mehrere auf gegenüberliegenden Seiten und einer weiteren Seite der beiden Anschlüsse (24, 26) angeordnete Messspulen (40, 40', 40") umfasst, wobei die Messspulen (40, 40') auf gegenüberliegenden Seiten der Anschlüsse (24, 26) in Bezug auf eine Richtung um die Anschlüsse (24, 26) gleichsinnig gewickelt sind und die Messspule (40") auf einer weiteren Seite der Anschlüsse (24, 26) gegensinnig gewickelt ist.

## Revendications

1. Procédé de détection d'un événement de court-circuit (46) dans un convertisseur multiniveau (42, 42'),
dans lequel le convertisseur (42) est composé d'au moins deux modules de puissance (M1, M2, M3, M3') interconnectés électriquement l'un avec l'autre pour générer une sortie multiniveau, et chacun des modules de puissance comprend un capteur de courant (30) adapté pour déterminer un courant le long d'un chemin d'écoulement à travers le module de puissance (M1, M2, M3, M3') ;
dans lequel chaque module de puissance comprend deux commutateurs à semi-conducteurs (12, 14) connectés électriquement en série ou en anti-série entre deux sorties (16, 18), l'un à l'autre, les deux sorties étant connectées à deux bornes (24, 26) placées l'une à côté de l'autre ;
le procédé comprenant les étapes suivantes :
déterminer pour chaque module de puissance (M1, M2, M3, M3') un signal de courant collectif (36) avec un capteur de courant (30, 34, 38) du module de puissance respectif, lequel signal de courant collectif (36) dépend de deux courants à travers les deux sorties (16, 18) du module de puissance (M1, M2, M3, M3') ;
déterminer un motif de signal de courant à partir des signaux de courant collectifs (36) en comparant chaque signal de courant collectif à un seuil ;
détecter l'événement de court-circuit (46) et identifier un chemin d'écoulement de court-circuit (P1 à P4) en recherchant le motif de signal de courant dans une table d'événements de court-circuit ;
**caractérisé en ce que** :
le signal de courant collectif est indicatif d'un courant différentiel des deux sorties du module de puissance, le courant différentiel étant une différence entre un courant entrant dans une sortie et un courant sortant de l'autre sortie ;
a) le capteur de courant comprend une bobine de Rogowski qui entoure les deux bornes ; ou
b) le capteur de courant comprend un dispositif de bobine de capture, qui comprend plusieurs bobines de mesure (40, 40', 40" ) disposées sur des côtés opposés et sur un autre côté des deux bornes (24, 26), où les bobines de mesure (40, 40') sur les côtés opposés des bornes (24, 26) sont enroulées dans la même direction par rapport à une direction autour des bornes (24, 26), et la bobine de mesure (40'') sur un autre côté des bornes (24, 26) est enroulée dans la direction opposée.

2. Procédé selon la revendication 1,
dans lequel, pour déterminer un motif de signal de courant, chaque signal de courant collectif (36) est comparé à une limite inférieure pour un courant de court-circuit en tant que seuil ;
où, pour chaque signal de courant collectif (36), le motif du signal de courant indique que le signal de courant collectif est supérieur au seuil, que le signal de courant collectif est inférieur à une valeur négative du seuil et/ou que le signal de courant collectif est compris entre la valeur négative du seuil et le seuil.

3. Procédé selon l'une des revendications précédentes, dans lequel un signal de courant collectif (36) est comparé à plus d'un seuil ;
dans lequel les seuils des différents signaux de courant collectif (36) sont différents.

4. Procédé selon l'une des revendications précédentes, comprenant en outre les étapes suivantes :
intégrer le signal de courant collectif (36), lequel signal de courant collectif (36) est indicatif d'une dérivée temporelle du courant traversant le module de puissance (M1, M2, M3, M3') ;
comparer le signal de courant collectif intégré au seuil.

5. Procédé selon l'une des revendications précédentes, comprenant en outre les étapes suivantes :
occulter les signaux de courant collectifs pendant des intervalles de temps spécifiques ; ou
annuler la détection d'événements de court-circuit pendant des intervalles de temps spécifiques.

6. Procédé selon l'une des revendications précédentes, comprenant en outre les étapes suivantes :
recevoir au moins un signal d'état de commutation indicatif d'un état de commutation d'au moins un des commutateurs à semi-conducteurs (12, 14) ;
identifier le chemin d'écoulement du court-circuit (P1 à P4) en recherchant le motif de signal de courant et en le combinant avec les informations d'état de commutation du courant.

7. Procédé selon l'une des revendications précédentes, dans lequel au moins un des modules de puissance (M1, M2, M3) est un module en demi-pont comprenant deux commutateurs à semi-conducteurs (12, 14) connectés en série entre une sortie DC+ (16) et une sortie DC- (18) et fournissant une sortie AC (20) entre eux.

8. Procédé selon la revendication 7,
dans lequel le convertisseur est un convertisseur NPC à 3 niveaux (42) comprenant deux modules en demi-pont et un module à diode en demi-pont ; et/ou
dans lequel le convertisseur est un convertisseur NPC à 3 niveaux (42) comprenant un module en demi-pont et deux modules hacheurs ; et/ou
dans lequel le convertisseur est un convertisseur ANPC à 3 niveaux (42) comprenant trois modules en demi-pont (M1, M2, M3), dans lequel deux modules en demi-pont sont interconnectés avec leurs sorties AC (20) avec les sorties DC (16, 18) d'un troisième module en demi-pont.

9. Procédé selon l'une des revendications précédentes, dans lequel au moins un des modules de puissance est un module de commutation bidirectionnel (M3') comprenant deux commutateurs à semi-conducteurs (12, 14) connectés en anti-série entre deux sorties ;
dans lequel le convertisseur est un convertisseur de type T (42') avec deux modules en demi-pont parallèles (M1, M2) interconnectés avec leurs sorties AC (20) avec une sortie d'un module de commutation bidirectionnel (M3').

10. Procédé selon l'une des revendications précédentes, dans lequel le capteur de courant (30) est adapté pour mesurer un courant dans une borne d'alimentation (24, 26) du module de puissance et/ou de la barre de bus interconnectée avec la borne d'alimentation du module de puissance.

11. Convertisseur électrique multiniveau (42, 42'), comprenant :
au moins deux modules de puissance (M1, M2, M3, M3') interconnectés électriquement l'un avec l'autre, chaque module de puissance comprenant deux commutateurs à semiconducteur (12, 14) connectés électriquement l'un avec l'autre et chaque module de puissance comprend un capteur de courant (30) adapté pour déterminer un courant à travers le module de puissance ;
un contrôleur (44) adapté pour exécuter le procédé selon l'une des revendications précédentes ;
dans lequel chaque module de puissance comprend deux commutateurs à semi-conducteurs (12, 14) connectés électriquement en série ou en anti-série entre deux sorties (16, 18) du module de puissance, l'un à l'autre, les deux sorties étant connectées à deux bornes (24, 26) placées l'une à côté de l'autre ;
dans lequel le capteur de courant (30) de chaque module de puissance est adapté pour déterminer un signal de courant collectif (36), qui dépend de deux courants à travers les deux sorties (16, 18) du module de puissance (M1, M2, M3, M3') ;
**caractérisé en ce que** :
le capteur de courant comprend une bobine de Rogowski qui entoure les deux bornes ; ou
le capteur de courant comprend un dispositif de bobine de capture, qui comprend plusieurs bobines de mesure (40, 40', 40'') disposées sur des côtés opposés et sur un autre côté des deux bornes (24, 26), où les bobines de mesure (40, 40') sur les côtés opposés des bornes (24, 26) sont enroulées dans la même direction par rapport à une direction autour des bornes (24, 26), et la bobine de mesure (40'') sur un autre côté des bornes (24, 26) est enroulée dans la direction opposée.
